# EUROPEAN PATENT SPECIFICATION

(11) **EP 0 580 454 B1**
(45) Date of publication and mention of the grant of the patent: **28.10.1998**
(21) Application number: 93305979.2
(22) Date of filing: 23.07.1993
(51) Int. Cl.: H04N 7/24, H04N 7/30

(54) **Coding and decoding of digital data**
Kodierung und Dekodierung von digitalen Daten
Codage et décodage de données numériques

(30) Priority: 23.07.1992 KR 1317192
(43) Date of publication of application: 26.01.1994
(73) Proprietor: SAMSUNG ELECTRONICS CO., LTD., Suwon-city, Kyungki-do 441-373 (KR)
(72) Inventor: Jeong, Jechang, Seocho-gum, Seoul (KR)
(74) Representative: Grünecker, Kinkeldey, Stockmair & Schwanhäusser Anwaltssozietät

(56) References cited:
- EP-A- 0 301 712
- US-A- 4 972 260
- US-A- 5 021 891

## Description

The present invention relates to the coding and decoding of digital data.

Recently, a method for coding a video and audio signal into digital data so as to be transmitted or stored in a storing unit, and decoding the coded digital data so as to be reproduced, has been used in a system for transmitting and receiving the video and audio signal. There has been needed a technique for compressing further the quantity of transmission data so as to optimize transmission efficiency of data in such a coding and decoding system. There have been a transformation coding method, a Differential Pulse Code Modulation (DPCM) method, a vector quantization method and a variable-length-coding method, etc., in the methods for, coding such transmitted or stored digital data. The coding methods compress a total quantity of data, by removing redundancy data which is included in the transmitted or stored digital data.

The video data of each frame are divided into a block units of a predetermined size and data-processed in a coding and decoding system for transmitting and receiving the video signal. Each block data or differential data between block data is orthogonal-transformed, so that the video data are transformed into transformation coefficients in frequency domain. There have been a Discrete Cosine Transform (DCT), a Walsh-Hadamard Transform (WHT), a Discrete Fourier Transform (DFT) and a Discrete Sine Transform (DST), etc., in such block data transformation methods. The transformation coefficients obtained by such transformation methods are coded properly according to the characteristic of coefficient data, so that compressed data are obtained. Since one's sight is more sensitive to low frequency than high frequency, the data in high frequency are reduced under data-precessing. Accordingly, the quantity of the coded data can be further decreased.

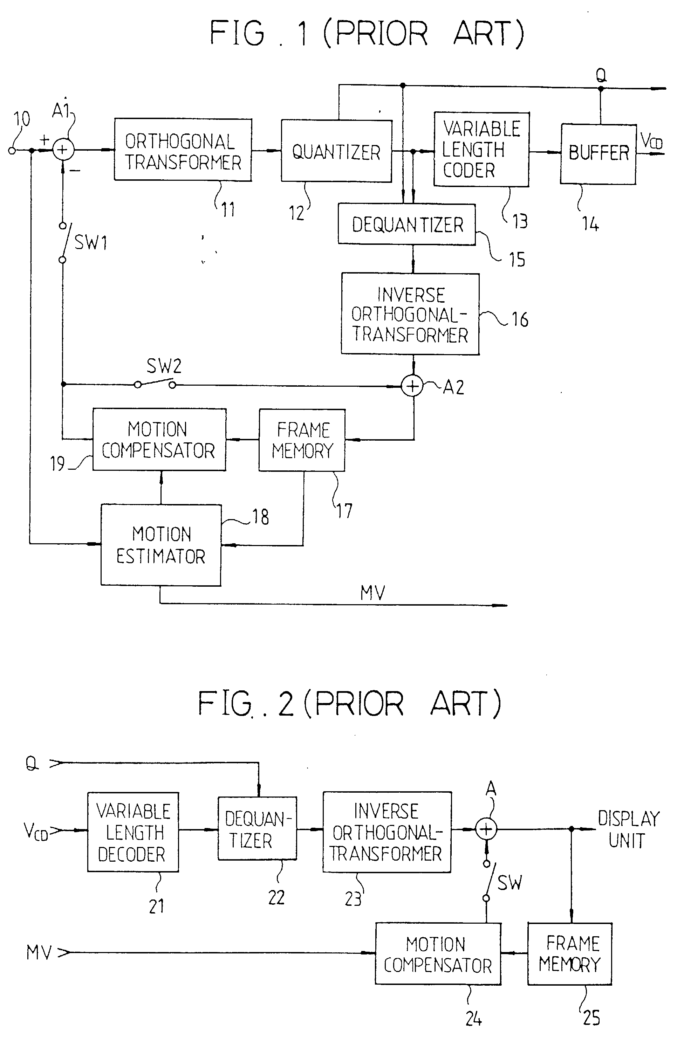

Figure 1 of the accompanying diagrammatic drawings represents a schematic block diagram of a conventional coding apparatus of video data. First, an input terminal 10 receives data blocks of size NxN (which is more generally represented as N1xN2, but which for the convenience of explanation will be assumed as N1=N2=N). The block data input through the input terminal 10 is added to predetermined feedback data in a first adder Al, thereby calculating differential data between the two data. An orthogonal transformer 11 discrete-cosine-transforms the input differential data, the differential data thereby being transformed into coefficients in frequency domain. A quantizer 12 changes coefficients transformed through a predetermined quantizing process into representative values of various level. Then, the quantizer 12 quantizes variably the output data from the orthogonal transformer-11 according to a quantization level (Q) input from a buffer 14. A variable length coder 13 variable-length-codes the block data taking statistical characteristics of quantization coefficients into consideration, such that transmitted data (VCD) is further compressed. A variable-length-coding procedure with respect to the video data will be described hereinafter. The buffer 14 is input with compression data from the variable length coder 13 and outputs the data to a transmission channel at a constant speed. Then, the quantization level (Q) is output for controlling the quantity of input data, so as to prevent, an overflow or an underflow in transmission data.

Generally, there are many similar patterns between adjacent frames in video data. Accordingly, in the case of slight motion of an image, the motion of the image is estimated by comparing a present frame with previous frames. A motion vector (MV) is calculated as a result of motion estimation. Motion compensation is achieved from previous frames with a motion vector. The quantity of differential data between block data obtained from motion compensation and block data input to the input terminal 10 is very small, so that the data can be further compressed in the above coding process. A feedback loop chain for performing the motion estimation and motion compensation consists of a dequantizer 15, an inverse orthogonal-transformer 16, a frame memory 17, a motion estimator 18 and a motion compensator 19. The dequantizer 15 and inverse orthogonal-transformer 16 dequantizes and inversely discrete-cosine-transforms the quantization coefficients output from the quantizer 12, and transforms them into video data in spatial domain. A second adder A2 adds the video data output from the inverse orthogonal-transformer 16 to the feedback data input via a second switch SW2, thereby outputting resultant block data. The block data output from the second adder A2 is stored in an ordered manner in the frame memory 17, thereby to reconstruct a frame. The motion estimator 18 catches the block data, which is the most similar data in pattern with the block data input via the input terminal 10, from the frame data stored in the frame memory 17, and calculates the motion vector MV for estimating the motion of images from the two block data. The motion vector MV is transmitted to a receiver and the motion compensator 19, in order to be used in a decoding system. The motion compensator 19 reads out the block data corresponding to the motion vector MV from the frame data in the frame memory 17, and inputs the read data to the first adder Al. As described above, the first adder Al calculates differential data between the block data input from the input terminal 10 and the block data input from the motion compensator 19, then the differential data is coded, and the coded data is transmitted to the receiver. Moreover, the two switches SW1 & SW2 in Figure 1 are refresh switches for refreshing the data in units of frame or block of a predetermined size, in order to prevent the difference between coded data of frames and unprocessed data of frames due to the accumulation of the differential data.

The coded video data (VCD) is transmitted to the receiver and input to a decoder such as is shown in Figure 2 of the accompanying diagrammatic drawings. A variable length decoder 21 decodes the input video data (VCD) via an inverse process of variable-length-coding. A dequantizer 22 decodes quantization coefficients input from the variable length decoder 21, thereby outputting transformation coefficients in frequency domain. An inverse orthogonal-transformer 23 transforms the transformation coefficients in frequency domain, which are input from the dequantizer 22, into video data in spatial domain. The motion vector MV output from the motion estimator 18 of the coder is input to a motion compensator 24 of the decoder. The motion compensator 24 reads out the block data corresponding to the motion vector MV from the frame data stored in a frame memory 25, and inputs the read data to an adder A. The adder A adds the differential data output from the inverse orthogonal-transformer 23 to the block data input from the motion compensator 24, thereby outputting resultant reconstructed block data. A switch SW connected to an output terminal of the motion compensator 24 plays the same role as the refresh switches of the above coder.

There has been used a Huffman Code for variable-length-coding in a conventional coding system. Huffman Coding allocates codes different in length to each other according to a probability of a predetermined symbol in input data. That is, the higher the probability is, the shorter the code allocated, and the lower the probability is, the longer the code allocated. In coding by means of a Huffman algorithm, in the case where there are multiforms of symbols in abundance, and many symbols have low probabilities, a plurality of long codes are allocated for rare symbols, and data-processing comes to be further complicated in the processes of coding and decoding. In order to solve the problem, in the case that a code with a predetermined fixed length is allocated for distribution area of a plurality of rare symbols (which is hereinafter referred to as an escape area), complexity of data-processing is highly reduced, even if an average code length can be increased more than an average value of original Huffman codes.

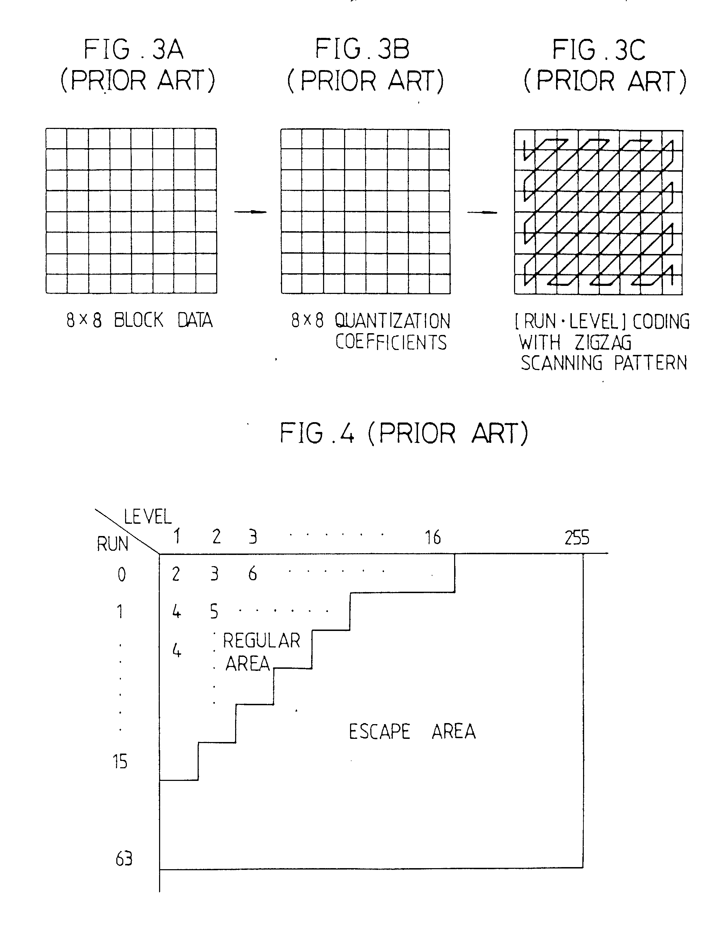

Figure 3A of the accompanying diagrammatic drawings represents block data of 8x8, Figure 3B shows 8x8 quantization coefficients which transform the block data of 8x8 into data in frequency domain and quantize the transformed data, and Figure 3C discloses a state that zigzag scans the quantization coefficients from low frequency to high frequency and codes the scanned coefficients into [run · level] symbols, considering that the most quantization coefficients are "0" in low frequency domain. Here, run means the sum of "0" being between coefficients not "0", level means absolute values of coefficients not "0". In the case of the block data 8x8 of Figure 3, the run can have values from "0" to "63". In the case that quantization output has integer values from "-255" to "+255", the level may have a value from "1" to "255", and a sign is separately indicated.

Figure 4 shows an escape area and a regulated classification according to probabilities of [run · level] symbols. A probability of symbols with a large value of run and/or level in [run · level] symbols is very low statistically. In a distribution area of symbols with a low probability, that is, an escape area, the symbols are dealt with as an escape sequence of fixed code length, and a regular Huffman code is allocated for the other areas (regular area). For example, in the case of 8x 8 block data, the escape sequence consists of 6-bit escape symbols, 6-bit runs for representing from "0" to "63", 8-bit levels for showing from "1" to "225" and a sign bit of 1-bit.

In this way, a conventional variable-length coding system has used a zigzag scanning pattern (shown in Figure 3) for NxN quantization coefficients in variable-length coding the video data, because energies of the video signal are concentrated at the low frequency domain centering around DC components. However, the energy of the video signal can be distributed much more to frequency components of a horizontal orientation or a vertical orientation, according to the pattern of the video signal. Therefore, a conventional zigzag scanning pattern can not be an optimised scanning pattern for variable-length-coding the video data. Accordingly, a scanning pattern which can be adaptably sloped to a horizontal orientation or a vertical orientation according to the distribution characteristics of the video data, would be desirable for variable length-coding and variable length decoding.

EP-A-0301712 discloses a data encoding apparatus and respective method. The reference suggests to divide each frame into a plurality of blocks each of which being scanned according to a plurality of different scanning patterns to select for each block the most appropriate scanning pattern. For this purpose the number of consecutive zeros resulting from each scanning pattern for a particular block are compared to each other by means of a minimum selector which selects that scan pattern for a particular block which has resulted in the highest amount of zeros for that particular block. According to page 4 lines 3 to 5 of the EP-A-0301712, the information concerning the selection of the scanning pattern for each individual block is added to the transmitted data in order to inform the corresponding decoder which scanning pattern should be used for the decoding of each individual block.

It is the object of the present invention to provide a coding and decoding apparatus as well as respective methods which use optimised scanning patterns for the coding and decoding without undue overload of the transmission channel and/or the medium storing the encooded data.

This object is solved by the subject matter of claims 1, 5 10 and 15.

According to one aspect the present invention provides a method for encoding video data comprising a frame divided into a plurality of data blocks of a predetermined size comprising the steps of:
scanning said data blocks according to plurality of different scanning patterns,
transforming said scanned data into run level symbols, said run level symbols representing run data and level data, said run data defining the number of zeros being between non-zero coefficients and said level data defining the values of non-zero coefficients,
variable length coding said run level symbols,
accumulating separately the various lengths of data which has been obtained in said variable length coding steps according to said plurality of different scanning patterns,
selecting a scanning pattern among said plurality of scanning patterns corresponding to a minimum value among the values of accumulated lengths of variable length coded data obtained in the preceding accumulating step, and
selecting as transmission data the data which has been variable length coded in said variable length coding step according to the scanning pattern selected in said selecting step.

Preferably said step for selecting a scanning pattern corresponding to a minimum value among the values of accumulated length of variable-length-coded data, includes a sub-step of selecting a minimum value among various accumulated values and simultaneously resetting to a predetermined initial value the accumulated values of said accumulating step.

Preferably said step for selecting a scanning pattern corresponding to a minimum value among the values of accumulated lengths of variable-length-coded data, includes a sub-step of selecting a minimum value among various accumulated values and simultaneously resetting to a predetermined initial value the variable-length-coded data of said variable-length-coding step.

Preferably a series of processes for variable-length-coding according to various scanning patterns are separately performed for all block data.

According to another aspect the present invention provides an encoder for encoding video data comprising a frame divided into a plurality of data blocks of a predetermined size comprising:
scanning means for scanning said data blocks according to a plurality of different scanning patterns,
run level coding means for transforming said scanned data into run level symbols, said run level symbols representing run data and level data, said run data defining the number of zeros being between non-zero coefficients and said level data defining the value of non-zero coefficients,
variable length coding means for variable length coding said run level symbols,
accumulating means for accumulating separately the various lengths of data which has been obtained in said variable length coding step according to each of said plurality of different scanning patterns,
scanning pattern selector for selecting a scanning pattern among said plurality of scanning patterns corresponding to a minimum value among the values of accumulated lengths of variable length coded data obtained in the preceding accumulating means, and
selecting means for selecting as transmission data the data which has been variable length coded in said variable length coding means according to the scanning pattern selected in said scanning pattern selector.

Preferably said accumulating means comprise adders for adding the lengths of variable-length-coded data which are input from said variable length coding means to a predetermined accumulated length which are fed back from a said accumulating means, and storing units for storing the output data of said adders to update accumulated lengths, and outputting the accumulated lengths to said adders.

Preferably said scanning pattern selector selects said minimum value and simultaneously inputs respective reset signals to buffers, said buffers storing variable-length-coded data output from said variable length coding means, thereby resetting said buffers to a predetermined initial value.

Preferably said scanning pattern selector selects said minimum value and simultaneously inputs respective reset signals to said accumulating means, thereby separately resetting said accumulators to a predetermined initial value.

Preferably said selecting signal input from said selecting means is a signal for selecting a buffer which stores variable-length-coded symbols according to a scanning pattern that corresponds to a selected minimum value in said scanning pattern selector.

According to further aspects the present invention provides a method of decoding encoded video data into video data comprising a frame divided into a plurality of data blocks of a predetermined size comprising the steps of:
variable length decoding encoded video data of each data block into run level symbols, said run level symbols representing run data and level data, said run data defining the number of zeros being between non- zero coefficients and said level data defining the values of non- zero coefficients;
converting said run level symbols into quantized coefficients by run level decoding said run level symbols;
scanning said quantized coefficients of every data block of said frame using a scanning pattern, said scanning pattern having been selected among a plurality of scanning patterns based on scanning pattern data indicating a scanning pattern used during coding of said frame.

Preferably the step of scanning comprises transforming said quantized coefficients into two-dimensional quantized coefficients.

Preferably said two-dimensional quantized coefficients are quantized coefficients stored at locations based on said scanning pattern such that said quantized coefficients stored at said memory locations correspond to a two-dimensional array of said quantized coefficients.

Preferably the method further comprises the step of dequantizing said quantized coefficients after said scanning step.

Preferably said scanning pattern data indicates one of a plurality of scanning patterns including a zigzag scanning pattern.

According to another aspect the invention provides means for decoding encoded video data into video data comprising a frame divided into a plurality of data blocks of a predetermined size, said decoder comprising:
variable !ength decoding means for transforming said encoded video data of each data block into run level symbols, said run level symbols representing run data and level data, said run data defining the number of zeros being between non- zero coefficients and said level data defining the values of non- zero coefficients;
run level decoding means for converting said run level symbols into quantized coefficients,
scanning pattern selection means for selecting a scanning pattern among a plurality of scanning patterns based on scanning pattern data indicating a scanning pattern used during coding of said frame, and
inverse scanning means for scanning said quantized coefficients of every data block of said frame using said scanning pattern provided by said scanning pattern selection means.

Preferably said decoder further comprises:
a dequantizer for dequantizing said coefficients after that coefficients are scanned.

Preferably the decoder further comprises:
a storage device for storing a plurality of scanning patterns; and
means for outputting a scanning order in accordance with said specific scanning pattern among said plurality of scanning patterns.

Preferably said plurality of scanning patterns includes zigzag scanning pattern.

For a better understanding of the invention, and to show how the same may be carried into effect, reference will now be made, by way of example, to Figures 5 to 7 of the accompanying diagrammatic drawings, in which:
Figure 5 is a block diagram showing one example of an embodiment of a variable-length-coder in accordance with the present invention;
Figure 6 is a block diagram showing one example of an embodiment or a variable-length-decoder in accordance with the present invention; and
Figure 7 is a conceptual diagram explaining scanning patterns in the apparatus of Figures 5 & 6.

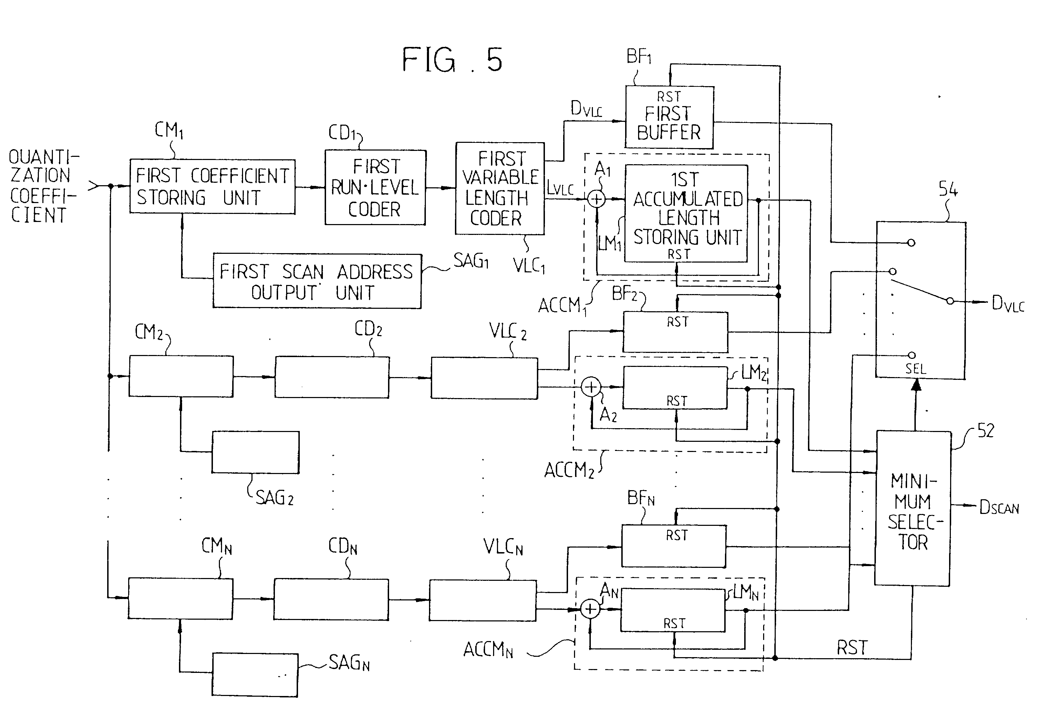

The coder of Figure 5 comprises N coefficient storing units (CMl-CMN) for respectively storing the quantization coefficients or quantized block data: N scan address output units (SAG1-SAGN) each for inputting different scan addresses to a respective one of the coefficient storing units; N [run · level] coders (CD1-CDN) each for [run · level] coding coefficients in a respective one of the coefficient storing units according to respective scanning patterns; N variable length coders (VLC1-VLCN) each for variable-length-coding [run · level] symbols output from a respective one of the [run · level] coders according to a variable-length-coding map; N buffers (BF1-BFN) each for storing the variable-length-coding data of a respective one of variable length coders (VLC1-VLCN); N accumulators (ACCM1-ACCMN) each for separately accumulating lengths of variable-length-coded data output from a respective one of the variable length coders (VLC1-VLCN); a minimum selector 52 for selecting a minimum value among accumulated lengths in the N accumulators (ACCM1-ACCMN); and a selecting switch 54 for selecting and transmitting the buffer output of variable-length-coding channels selected in the minimum selector 52.

First, the quantization coefficients which are quantized in block units of a predetermined size are stored in each of the N coefficient storing units (CM1-CMN). The first, second... and N coefficient storing units are respectively input with the first, second. . . and N scan addresses which are separately output from the first, second, and N scan address output units. A coding channel will be described for the first coefficient storing unit (CM1) among N coefficient storing units which are scanned by each of N scan addresses.

The quantization coefficients stored in the first coefficient storing unit (CM1) are scanned toward a predetermined scanning orientation by the first scan address, and coded to a [run · level] symbol in the first [run · level] coder (CD1). The first variable length coder (VLC1) variable-length-codes the [run · level] symbol input from the first [run · level] coder (CD1) according to a predetermined variable-length-coding map, and respectively outputs variable-length-coded data (DVLC) and a length of variable-length-coded data (LVLC). The variable-length-coded data (DVLC) output from the first variable length coder (VLCl) is stored in the first buffer (BF1), and the length of variable-length-coded data (LVLC) is input and accumulated to the first accumulator (ACCMI) which accumulates the lengths of code that are coded by the first unit (VLCl). Here, the first accumulator (ACCM1) consists of an adder (A1) and an accumulated length storing unit (LM1) The length of variable-length-coded data (LvLc) which are input from the first variable length coder (VLCl) are added to accumulated lengths which are fedback from the first accumulated length storing unit (LMl) in the adder (A1). The first accumulated length storing unit (LM1 restores an update accumulated length output from the adder (A1).

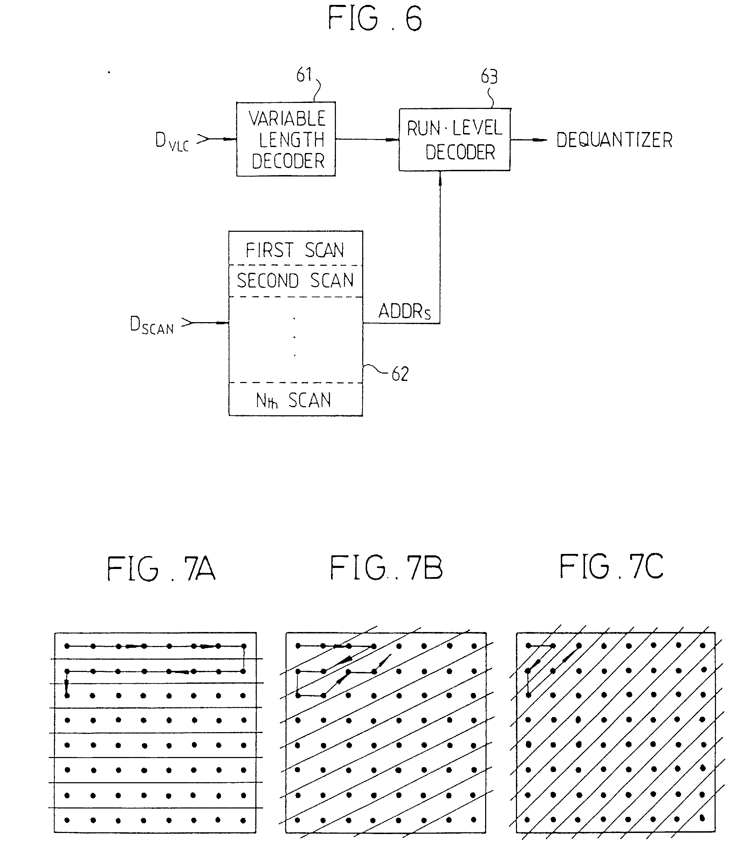

A series of such coding channels are applied to the quantization coefficients of the second, third, ··and N coefficient storing units (CM2, CM3, ··, CMN) However, patterns for scanning the quantization coefficients in block units which are respectively stored in N coefficient storing units, are different each other. Figure 7 shows different scanning patterns. A scanning pattern of Figure 7A has a scanning orientation of 0 degrees, that of Figure 7B 30 degrees and that of Figure 7C 45 degrees.

In channels of variable-length-coding with various scanning patterns, N accumulators (ACCM1-ACCMN) respectively provides the accumulated length data stored in each of the accumulated length storing units, to N input terminals of the minimum selector 52 for a minimum value of accumulated lengths. Each output terminal of N buffers (BF1-BFN), which store the variable-length-coded data according to N kinds of scanning patterns, is separately connected to a respective one of N input terminals of the selecting switch 54. The minimum selector 52 selects a minimum value among accumulated length data input from each of the N accumulated length storing units (LM1-LMN). The minimum selector 52 outputs a scanning pattern data (DSCAN) which represents scanning patterns of accumulated lengths, and provides a predetermined selecting control signal (SEL) corresponding to the selected minimum value of accumulated lengths to the selecting switch 54. The selecting switch 54 selects and outputs a variable-length-coded data (DVLC) with the minimum value of accumulated lengths among the input data which are respectively input to N input terminals.

Whenever a minimum value is selected, that is, the variable-length-coding of every block data is completed, the minimum selector 52 generates a reset signal (RST), whereby the N buffers (BF1 -BFN) and the N accumulated length storing units (LM1-LMN) are reset. The variable-length-coded data (DvLc) and the scanning pattern data (DscAN), which are output from the variable length coder, are transmitted to the receiver and supplied to a decoder.

Referring now to the variable length decoder of Figure 6, the input variable-length-coded data (DvLc) are input to a variable length decoder 61 and transformed to a [run · level] symbol according to a variable-length-decoding map. Moreover, the scanning pattern data (DSCAN) transmitted from the coder are input to a scanning pattern selector 62 which stores each of the scanning addresses corresponding to various scanning patterns (1, ·· N scans). The scanning pattern selector 62 selects and outputs scan addresses (ADDRS) corresponding to the input scanning pattern data (DscAN). A [run · level] decoder 63 transforms the [run · level] symbols input from the variable length decoder 61 into a two-dimensional quantization coefficient according to the scan addresses (ADDRS) input from the scanning pattern selector 62. Then, the quantization coefficients are provided to a dequantizer.

The above-described variable-length-decoder system variable-length-codes everry block data according to diverse scanning patterns, and transmits both an optimised scanning pattern which minimizes the length of variable-length-coded data and variable-length-coded data according to the scanning pattern. The variable-length-decoding system variable-length-decodes the transmitted variable-length-coded data according to the same scanning pattern as utilized in the process of variable-length-coding. As a result, the system for variable-lenght-coding and variable-length-decoding can further improve compression of the transmission data.

While embodiments of the present invention have been illustrated with respect to two-dimensional data, other embodiments of the invention may be applied to a coding and decoding system which utilizes multi-dimensional data.

## Claims

1. A method for encoding video data comprising a frame divided into a plurality of data blocks of a predetermined size comprising the steps of:
scanning said data blocks according to plurality of different scanning patterns,
transforming said scanned data into run level symbols, said run level symbols representing run data and level data, said run data defining the number of zeros being between non-zero coefficients and said level data defining the values of non-zero coefficients,
variable length coding said run level symbols,
accumulating separately the various lengths of data which has been obtained in said variable length coding steps according to said plurality of different scanning patterns,
selecting a scanning pattern among said plurality of scanning patterns corresponding to a minimum value among the values of accumulated lengths of variable length coded data obtained in the preceding accumulating step, and
selecting as transmission data the data which has been variable length coded in said variable length coding step according to the scanning pattern selected in said selecting step.

2. A method according to claim 1 wherein said step for selecting a scanning pattern corresponding to a minimum value among the values of accumulated length of variable-length-coded data, includes a sub-step of selecting a minimum value among various accumulated values and simultaneously resetting to a predetermined initial value the accumulated values of said accumulating step.

3. A method according to claim 1, wherein said step for selecting a scanning pattern corresponding to a minimum value among the values of accumulated lengths of variable-length-coded data, includes a sub-step of selecting a minimum value among various accumulated values and simultaneously resetting lo a predetermined initial value the variable-length-coded *data* of said variable-length-coding step.

4. A method according to one of the claims 1, 2, 3, wherein a series of processes for variable-length-coding according to various scanning patterns are separately performed for all block data.

5. An encoder for encoding video data comprising a frame divided into a plurality of data blocks of a predetermined size comprising:
scanning means for scanning said data blocks according to a plurality of different scanning patterns,
run level coding means (CD) for transforming said scanned data into run level symbols, said run level symbols representing run data and level data, said run data defining the number of zeros being between non-zero coefficients and said level data defining the value of non-zero coefficients,
variable length coding means (VLC) for variable length coding said run level symbols,
accumulating means (ACCM) for accumulating separately the various lengths of data which has bean obtained in said variable length coding step according to each of said plurality of different scanning patterns,
scanning pattern selector (52) for selecting a scanning pattern among said plurality of scanning patterns corresponding to a minimum value among the values of accumulated lengths of variable length coded data obtained in the preceding accumulating means, and
selecting means (54) for selecting as transmission data the data which has been variable length coded in said variable length coding means according to the scanning pattern selected in said scanning pattem selector.

6. An encoder according to plan 5, wherein said accumulating means (ACCM1-ACCMN) comprise adders (A1-AN) for adding the lengths of variable-length-coded data which are input from said variable length coding means (VLC1-VLCN) to a predetermined accumulated length which are fed back from a said accumulating means, and storing units (LM1-LMN) for storing the output data of said adders (A1-AN) to update accumulated lengths, and outputting the accumulated lengths to said adders.

7. An encoder according to claims 5 or 6, wherein said scanning pattern selector (52) selects said minimum value and simultaneously inputs respective reset signals to buffers (BF1-BFN), said buffers storing variable-length-coded data output from said variable length coding means, thereby resetting said buffers to a predetermined initial value.

8. An encoder according to claims 5, 6 or 7, wherein said scanning pattern selector selects said minimum value and simultaneously inputs respective reset signals to said accumulating means (ACCM1-ACCMN), thereby separately resetting said accumulators to a predetermined initial value.

9. An encoder according to claim 5, wherein a selecting signal input from said selecting means (54) is a signal for selecting a buffer which stores variable-length-coded symbols according to a scanning pattern that corresponds to a selected minimum value in said scanning pattern selector (52).

10. A method of decoding encoded video data into video data comprising a frame divided into a plurality of data blocks of a predetermined size comprising the steps of:
variable length decoding encoded video data of each data block into run level symbols, said run level symbols representing run data and level data, said run data defining the number of zeros being between non- zero coefficients and said level data defining the values of non- zero coefficients;
converting said run level symbols into quantized coefficients by run level decoding said run level symbols;
scanning said quantized coefficients of every data block of said frame using a scanning pattern, said scanning pattern having been selected among a plurality, of scanning patterns based on scanning pattern data indicating a scanning pattern used during coding of said frame.

11. A method of decoding data according to claim 10 wherein the step of scanning comprises transforming said quantized coefficients into two-dimensional quantized coefficients.

12. A method of decoding according to claim 11, wherein said two-dimensional quantized coefficients are quantized coefficients stored at locations based on said scanning pattern such that said quantized coefficients stored at said memory locations correspond to a two-dimensional array of said quantized coefficients.

13. A method of decoding according to any one of the claims 10 to 12, further comprising the step of dequantizing said quantized coefficients after said scanning step.

14. A method of decoding according to one of the claims 10 to 13, wherein said scanning pattern data indicates one of a plurality of scanning patterns including a zigzag scanning pattern.

15. A decoder for decoding encoded video data into video data comprising a frame divided into a plurality of data blocks of a predetermined size, said decoder comprising:
variable length decoding means for transforming said encoded video data of each data block into run level symbols, said run level symbols representing run data and level data, said run data defining the number of zeros being between non- zero coefficients and said level data defining the values of non- zero coefficients;
run level decoding means for converting said run level symbols into quantized coefficients,
scanning pattern selection means for selecting a scanning pattern among a plurality of scanning patterns based on scanning pattern data indicating a scanning pattern used during coding of said frame, and
inverse scanning means for scanning said quantized coefficients of every data block of said frame using said scanning pattern provided by said scanning pattern selection means.

16. A decoder according to claim 15 further comprising:
a dequantizer for dequantizing said coefficients after that coefficients are scanned.

17. A decoder according to one of the claims 15 or 16, further comprising:
a storage device (62) for storing a plurality of scanning patterns; and
means (62) for outputting a scanning order in accordance with said spacific scanning pattern among said plurality of scanning patterns.

18. A decoder according to claim 17, wherein said plurality of scanning patterns includes zigzag scanning pattern.

## Patentansprüche

1. Verfahren zur Codierung von Videodaten eines Vollbildes, das in eine Mehrzahl von Datenblöcke vorbestimmter Größe unterteilt ist, wobei das Verfahren die folgenden Schritte umfaßt:
Abtasten der Datenblöcke mit einer Mehrzahl verschiedener Abtastmuster,
Transformieren der abgetasteten Daten in Lauf-Pegel-Symbole, wobei die Lauf-Pegel-Symbole Lauf-Daten und Pegel-Daten darstellen, die Lauf-Daten bestimmen die Anzahl von Nullen zwischen Nicht-Null-Koeffizienten und die Pegel-Daten bestimmen die Werte der Nicht-Null-Koeffizienten,
Variable-Längen-Codierung der Lauf-Pegel-Symbole,
getrenntes Akkumulieren der verschiedenen Datenlängen, die in dem Variable-Längen-Codierungsschritt für die Mehrzahl der verschiedenen Abtastmuster erhalten wurden,
Auswählen eines Abtastmusters aus der Mehrzahl von Abtastmustern entsprechend einem Minimumwert der Werte akkumulierter Längen der mit variabler Länge codierten Daten, die in dem vorausgehenden Akkumulierungsschritt erhalten wurden, und
Auswählen der Daten als Übertragungsdaten, die mit variabler Länge in dem Variable-Längen-Codierungsschritt gemäß dem in dem Auswahlschritt ausgewählten Abtastmuster codiert wurden.

2. Verfahren nach Anspruch 1, wobei der Schritt zum Auswählen eines Abtastmusters entsprechend einem Minimumwert aus den Werten akkumulierter Längen mit variabler Länge codierter Daten einen Unterschritt zum Auswählen eines Minimumwertes aus verschiedenen akkumulierten Werten und zum gleichzeitigen Rücksetzen der akkumulierten Werte des Akkumulierungsschrittes auf einen vorbestimmten Anfangswert umfaßt.

3. Verfahren nach Anspruch 1, wobei der Schritt zum Auswählen eines Abtastmusters entsprechend einem Minimumwert aus den Werten akkumulierter Längen mit variabler Länge codierter Daten einen Unterschritt zum Auswählen eines Minimumwertes aus verschiedenen akkumulierten Werten und zum gleichzeitigen Rücksetzen der mit variabler Länge codierten Daten des Variable-Längen-Codierungsschrittes auf einen vorbestimmten Anfangswert umfaßt.

4. Verfahren nach einem der Ansprüche 1, 2, 3, wobei eine Folge von Verarbeitungsschritten zum Variable-Längen-Codieren gemäß verschiedenen Abtastmustern getrennt für alle Blockdaten ausgeführt wird.

5. Coder zur Codierung von Videodaten eines Vollbildes, das in eine Mehrzahl von Datenblöcken vorbestimmter Größe unterteilt ist, mit:
einer Abtasteinrichtung zur Abtastung der Datenblöcke mit einer Mehrzahl verschiedener Abtastmuster,
einer Lauf-Pegel-Codiereinrichtung (CD) zur Transformierung der abgetasteten Daten in Lauf-Pegel-Symbole, wobei die Lauf-Pegel-Symbole Lauf-Daten und Pegel-Daten darstellen, die Lauf-Daten bestimmen die Anzahl von Nullen zwischen Nicht-Null-Koeffizienten und die Pegel-Daten bestimmen den Wert von Nicht-Null-Koeffizienten,
einer Variable-Längen-Codiereinrichtung (VLC) zur Variablen-Längen-Codierung der Lauf-Pegel-Symbole,
Akkumulierungseinrichtungen (ACCM) zur getrennten Akkumulierung der verschiedenen Datenlängen, die in dem Variable-Längen-Codierungsschritt für jedes der Mehrzahl verschiedener Abtastmuster erhalten wurden,
einer Abtastmusterauswahleinrichtung (52) zur Auswahl eines Abtastmusters aus der Mehrzahl von Abtastmustern entsprechend einem Minimumwert der Werte akkumulierter Längen mit variabler Länge codierter Daten, die in den vorausgehenden Akkumulierungseinrichtungen erhalten wurden, und
einer Auswahleinrichtung (54) zur Auswahl der Daten als Übertragungsdaten, die in der Variable-Längen-Codiereinrichtung mit variabler Länge gemäß dem in der Abtastmusterauswahleinrichtung ausgewählten Abtastmuster codiert wurden.

6. Coder nach Anspruch 5, wobei die Akkumulierungseinrichtungen (ACCM1-ACCMN) Addierer (A1-AN) zur Addierung der Längen oder mit variabler Länge codierten Daten, die von der Variable-Längen-Codiereinrichtung (VLC1-VLCN) zu einer vorbestimmten akkumulierten Länge, die von den Akkumulierungseinrichtungen zurückgeführt werden, eingegeben werden, und Speichereinheiten (LM1-LMN) zur Speicherung der Ausgabedaten der Addierer (A1-AN) für die Aktualisierung der akkumulierten Längen und zur Ausgabe der akkumulierten Längen an die Addierer umfassen.

7. Coder nach Anspruch 5 oder 6, wobei die Abtastmusterauswahleinrichtung (52) den Minimumwert auswählt und gleichzeitig jeweils Rücksetzsignale den Puffern (BF1-BFN) zuführt, wobei die Puffer mit variabler Länge codierte Daten speichern, die von der Variable-Längen-Codiereinrichtung ausgegeben werden, wodurch die Puffer auf einen vorbestimmten Anfangswert zurückgesetzt werden.

8. Coder nach Anspruch 5, 6 oder 7, wobei die Abtastmusterauswahleinrichtung den Minimumwert auswählt und gleichzeitig jeweils Rücksetzsignale den Akkumulierungseinrichtungen (ACCM1-ACCMN) zuführt, wodurch die Akkumulatoren getrennt auf einen vorbestimmten Anfangswert zurückgesetzt werden.

9. Coder nach Anspruch 5, wobei ein Auswahlsignal, das von der Auswahleinrichtung (54) zugeführt wird, ein Signal zur Auswahl eines Puffers darstellt, der mit variabler Länge codierte Symbole gemäß einem Abtastmuster speichert, das einem in der Abtastmusterauswahleinrichtung (52) ausgewählten Minimumwert entspricht.

10. Verfahren zur Decodierung codierter Videodaten in Videodaten eines Vollbildes, das in eine Mehrzahl von Datenblöcke vorbestimmter Größe unterteilt ist, wobei das Verfahren die folgenden Schritte umfaßt:
Variable-Längen-Decodierung codierter Videodaten jedes Datenblocks in Lauf-Pegel-Symbole, wobei die Lauf-Pegel-Symbole Lauf-Daten und Pegel-Daten darstellen, die Lauf-Daten bestimmen die Anzahl von Nullen zwischen Nicht-Null-Koeffizienten und die Pegeldaten bestimmen die Werte von Nicht-Null-Koeffizienten;
Umwandeln der Lauf-Pegel-Symbole in quantisierte Koeffizienten durch Lauf-Pegel-Decodierung der Lauf-Pegel-Symbole;
Abtasten der quantisierten Koeffizienten jedes Datenblocks des Vollbildes unter Verwendung eines Abtastmusters, wobei das Abtastmuster aus einer Mehrzahl von Abtastmustern basierend auf Abtastmusterdaten, die ein Abtastmuster angeben, das bei der Codierung des Vollbildes verwendet wurde, ausgewählt wurde.

11. Verfahren zur Decodierung von Daten nach Anspruch 10, wobei der Schritt zur Abtastung ein Transformieren der quantisierten Koeffizienten in zweidimensionale, quantisierte Koeffizienten umfaßt.

12. Verfahren zur Decodierung nach Anspruch 11, wobei die zweidimensionalen, quantisierten Koeffizienten quantisierte Koeffizienten darstellen, die an Stellen gespeichert sind, die auf dem Abtastmuster basieren, so daß die quantisierten Koeffizienten, die an den Speicherstellen gespeichert sind, einer zweidimensionalen Matrix der quantisierten Koeffizienten entsprechen.

13. Verfahren zur Decodierung nach einem der Ansprüche 10 bis 12, wobei das Verfahren außerdem den Schritt zur Dequantisierung der quantisierten Koeffizienten nach dem Abtastschritt umfaßt.

14. Verfahren zur Decodierung nach einem der Ansprüche 10 bis 13, wobei die Abtastmusterdaten eines einer Mehrzahl von Abtastmustern einschließlich eines zickzackförmigen Abtastmusters angeben.

15. Decoder zur Decodierung codierter Videodaten in Videodaten eines Vollbildes, das in eine Mehrzahl von Datenblöcke vorbestimmter Größe unterteilt ist, wobei der Decoder umfaßt:
eine Variable-Längen-Decodiereinrichtung zur Transformierung der codierten Videodaten jedes Datenblocks in Lauf-Pegel-Symbole, wobei die Lauf-Pegel-Symbole Lauf-Daten und Pegel-Daten darstellen, die Lauf-Daten bestimmen die Anzahl von Nullen zwischen Nicht-Null-Koeffizienten und die Pegel-Daten bestimmten die Werte der Nicht-Null-Koeffizienten,
eine Lauf-Pegel-Decodiereinrichtung zur Umwandlung der Lauf-Pegel-Symbole in quantisierte Koeffizienten,
eine Abtastmusterauswahleinrichtung zur Auswahl eines Abtastmusters aus einer Mehrzahl von Abtastmustern basierend auf Abtastmusterdaten, die ein Abtastmuster angeben, das bei der Codierung des Vollbildes verwendet wurde, und
eine inverse Abtasteinrichtung zur Abtastung der quantisierten Koeffizienten jedes Datenblocks des Vollbildes unter Verwendung des Abtastmusters, das von der Abtastmusterauswahleinrichtung bereitgestellt wird.

16. Decoder nach Anspruch 15, wobei der Decoder außerdem umfaßt:
einen Dequantisierer zur Dequantisierung der Koeffizienten nach der Abtastung der Koeffizienten.

17. Decoder nach einem der Ansprüche 15 oder 16, wobei der Decoder außerdem umfaßt:
eine Speichereinrichtung (62) zur Speicherung einer Mehrzahl von Abtastmustern; und
eine Einrichtung (62) zur Ausgabe einer Abtastreihenfolge in Übereinstimmung mit dem bestimmten Abtastmuster aus der Mehrzahl von Abtastmustern.

18. Decoder nach Anspruch 17, wobei die Mehrzahl von Abtastmustern ein zickzackförmiges Abtastmuster enthält.

## Revendications

1. Procédé pour coder des données vidéo comprenant une trame divisée en une pluralité de blocs de données d'une taille prédéterminée comprenant les étapes consistant à :
balayer lesdits blocs de données selon une pluralité de motifs de balayage différents,
transformer lesdites données balayées en symboles de niveau d'exécution, lesdits symboles de niveau de passage représentant des données d'exécution et des données de niveau, lesdites données d'exécution définissant le nombre de zéros compris entre des coefficients non nuls et lesdites données de niveau définissant les valeurs de coefficients non nuls,
ladite longueur variable codant lesdits symboles de niveau d'exécution,
accumuler séparément les longueurs diverses de données qui ont été obtenues dans lesdites étapes de codage de longueur variable selon ladite pluralité de motifs de balayage différents,
sélectionner un motif de balayage parmi ladite pluralité de motifs de balayage correspondant à une valeur minimale parmi les valeurs de longueurs accumulées de données codées de longueur variable obtenue lors de l'étape d'accumulation précédente, et
sélectionner comme données de transmission les données qui ont été codées lors de ladite étape de codage de longueur variable selon le motif de balayage choisi dans ladite étape de sélection.

2. Procédé selon la revendication 1, dans lequel ladite étape pour sélectionner un motif de balayage correspondant à une valeur minimale parmi les valeurs de longueurs accumulées de données codées de longueur variable, comprend une sous-étape consistant à sélectionner une valeur minimale parmi diverses valeurs accumulées et en même temps à réinitialiser les valeurs accumulées de ladite étape d'accumulation sur la valeur initiale prédéterminée.

3. Procédé selon la revendication 1, dans lequel ladite étape pour sélectionner un motif de balayage correspondant à une valeur minimale parmi les valeurs de longueurs accumulées de données codées de longueurs variables, comprend une sous-étape consistant à sélectionner une valeur minimale parmi les diverses valeurs accumulées et à réinitialiser en même temps sur la valeur initiale prédéterminée les données codées de longueur variable de ladite étape de codage de longueur variable.

4. Procédé selon l'une des revendications 1, 2, 3, dans lequel une série de procédés de codage de longueur variable selon des motifs de balayage divers est réalisée séparément pour toutes les données en bloc.

5. Codeur pour coder des données vidéo comprenant une trame divisée en une pluralité de blocs de données d'une taille prédéterminée, comprenant :
des moyens de balayage pour balayer lesdits blocs selon une pluralité de motifs de balayage différents,
des moyens de codage de niveau d'exécution (CD) pour transformer lesdites données balayées en symboles de niveau d'exécution, lesdits symboles de niveau d'exécution représentant des données d'exécution et des données de niveau, lesdites données d'exécution définissant le nombre de zéros compris entre des coefficients non nuls et lesdites données de niveau définissant la valeur des coefficients non nuls,
des moyens de codage de longueur variable (VLC) pour effectuer un codage de longueur variable desdits symboles de niveau d'exécution,
des moyens d'accumulation (ACCM) pour accumuler séparément les diverses longueurs de données qui ont été obtenues lors de ladite étape de codage de longueur variable selon chaque motif parmi ladite pluralité de motifs de balayage différents,
un sélecteur (52) de motif de balayage pour sélectionner un motif de balayage parmi ladite pluralité de motifs de balayage correspondant à une valeur minimale parmi les valeurs de longueurs accumulées des données codées de longueur variable obtenues dans les moyens d'accumulation précédents, et
des moyens de sélection (54) pour sélectionner comme données de transmission les données pour lesquelles on a effectué un codage de longueur variable dans lesdits moyens de codage de longueur variable selon le motif de balayage sélectionné dans ledit sélecteur de motif de balayage.

6. Codeur selon la revendication 5, dans lequel lesdits moyens d'accumulation (ACCM1-ACCMN) comprennent des additionneurs (A1-AN) pour ajouter les longueurs des données codées de longueur variable qui sont entrées à partir desdits moyens de codage de longueur variable (VLC1-VLCN) pour une longueur accumulée prédéterminée qui sont ramenées à partir desdits moyens d'accumulation, et stocker des unités (LM1-LMN) pour stocker les données sorties desdits additionneurs (A1-AN) pour mettre à jour les longueurs accumulées, et délivrer les longueurs accumulées auxdits additionneurs.

7. Codeur selon les revendications 5 ou 6, dans lequel ledit sélecteur de motif de balayage (52) sélectionne ladite valeur minimale et en même temps délivre des signaux de remise à zéro respectifs à des tampons (BF1-BFN), lesdits tampons stockant les données codées de longueur variable délivrées depuis lesdits moyens de codage de longueur variable, réinitialisant ainsi lesdits tampons à une valeur initiale prédéterminée.

8. Codeur selon les revendications 5, 6 ou 7, dans lequel ledit sélecteur de motif de balayage sélectionne ladite valeur minimale et délivre simultanément des signaux de remise à zéro respectifs auxdits moyens d'accumulation (ACCM1-ACCMN), réinitialisant ainsi séparément lesdits accumulateurs à une valeur initiale prédéterminée.

9. Codeur selon la revendication 5, dans lequel un signal de sélection entré à partir desdits moyens de sélection (54) est un signal pour sélectionner un tampon qui stocke les symboles codés de longueur variable selon un motif de balayage qui correspond à une valeur minimale sélectionnée dans ledit sélecteur de motif de balayage (52).

10. Procédé de décodage de données vidéo codées en des données vidéo comprenant une trame divisée en une pluralité de blocs de données d'une taille prédéterminée comprenant les étapes consistant à :
avoir des données vidéo codées à décodage de longueur variable de chacun des blocs de données en symboles de niveau d'exécution, lesdits symboles de niveau d'exécution représentant des données d'exécution et des données de niveau, lesdites données d'exécution définissant le nombre de zéros se trouvant entre des coefficients non nuls et lesdites données de niveau définissant les valeurs des coefficients non nuls ;
convertir lesdits symboles de niveau d'exécution en coefficients quantifiés par le décodage de niveau d'exécution desdits symboles de niveau d'exécution ;
balayer lesdits coefficients quantifiés de chaque bloc de données de ladite trame en utilisant un motif de balayage, le motif de balayage ayant été sélectionné parmi une pluralité de motifs de balayage se basant sur des données de motifs de balayage indiquant un motif de balayage utilisé pendant le codage de ladite trame.

11. Procédé de décodage de données selon la revendication 10, dans lequel l'étape de balayage comprend la transformation desdits coefficients quantifiés en des coefficients quantifiés à deux dimensions.

12. Procédé de décodage selon la revendication 11, dans lequel lesdits coefficients quantifiés à deux dimensions sont des coefficients quantifiés stockés à des emplacements basés sur ledit motif de balayage de sorte que lesdits coefficients quantifiés au niveau desdits emplacements de mémoire correspondent à un ensemble bidimensionnel desdits coefficients quantifiés.

13. Procédé de décodage selon l'une quelconque des revendications 10 à 12, comprenant en outre l'étape consistant à déquantifier lesdits coefficients quantifiés après ladite étape de balayage.

14. Procédé de décodage selon l'une des revendications 10 à 13, dans lequel lesdites données de motif de balayage indiquent un motif parmi la pluralité de motifs de balayage comprenant un motif de balayage en zigzag.

15. Décodeur pour décoder des données vidéo codées en données vidéo comprenant une trame divisée en une pluralité de blocs de données d'une taille prédéterminée, ledit décodeur comprenant :
des moyens de décodage de longueur variable pour transformer lesdites données vidéo codées de chaque bloc de données en symboles de niveau d'exécution, lesdits symboles de niveau d'exécution représentant des données d'exécution et des données de niveau, lesdites données d'exécution définissant le nombre de zéros compris entre des coefficients non nuls et lesdites données de niveau définissant les valeurs de coefficients non nuls ;
des moyens de décodage de niveau d'exécution pour convertir lesdits symboles de niveau d'exécution en coefficients quantifiés ;
des moyens de sélection de motif de balayage pour sélectionner un motif de balayage parmi une pluralité de motifs de balayage en se basant sur des données de motif de balayage indiquant un motif de balayage utilisé pendant le codage de ladite trame, et
des moyens de balayage inverse pour balayer lesdits coefficients quantifiés de chaque bloc de données de ladite trame en utilisant ledit motif de balayage fourni par lesdits moyens de sélection de motif de balayage.

16. Décodeur selon la revendication 15, comprenant en outre :
un déquantifieur pour déquantifier lesdits coefficients après que les coefficients ont été balayés.

17. Décodeur selon l'une des revendications 15 ou 16, comprenant en outre :
un dispositif de stockage (62) pour stocker une pluralité de motifs de balayage ; et
des moyens (62) pour délivrer un ordre de balayage conformément audit motif de balayage spécifique parmi ladite pluralité de motifs de balayage.

18. Décodeur selon la revendication 17, dans lequel ladite pluralité de motifs de balayage comprend un motif de balayage en zigzag.
